(19) Europäisches Patentamt
European Patent Office
Office européen des brevets

(11) EP 1 533 847 A1

(12) EUROPEAN PATENT APPLICATION
published in accordance with Art. 158(3) EPC

(43) Date of publication:
25.05.2005 Bulletin 2005/21

(51) Int Cl.⁷: $H01L\ 27/146$, $H01L\ 21/322$

(21) Application number: 03733470.3

(22) Date of filing: 17.06.2003

(86) International application number:
PCT/JP2003/007648

(87) International publication number:
WO 2004/004012 (08.01.2004 Gazette 2004/02)

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(30) Priority: 26.06.2002 JP 2002186590

(71) Applicant: Nikon Corporation
Tokyo 100-8331 (JP)

(72) Inventors:
• ISHIDA, Tomohisa c/o NIKON CORPORATION
Chiyoda-ku, Tokyo 100-8331 (JP)
• KAMASHITA, Atsushi
c/o NIKON CORPORATION
Chiyoda-ku, Tokyo 100-8331 (JP)
• SUZUKI, Satoshi c/o NIKON CORPORATION
Chiyoda-ku, Tokyo 100-8331 (JP)

(74) Representative: Volpert, Marcus, Dr.
Albert-Rosshaupter-Strasse 73
81369 München (DE)

(54) SOLID IMAGING DEVICE

(57) A solid-state image sensor of the present invention has a plurality of pixel cells that generate signal charges in accordance with incident light. It is **characterized by** having a gettering region within the area of a pixel cell. The gettering region, which is disposed closely to the pixel cell, makes direct and efficient use of gettering capability in the pixel region in the solid-state image sensor. As a result, it is possible to effectively eliminate metal contaminant contained in the pixel region, thereby remarkably reducing dark outputs occurring from the metal contaminant.

FIG. 3

PERIPHERAL CIRCUITRY 12 | PIXEL CELL 11 | PIXEL CELL 11 | PIXEL CELL 11

LIGHT-BLOCKING FILM 15

PD

Qt

17

A — A'

13 WELL

20 GETTERING REGION

EP 1 533 847 A1

## Description

Technical Field

The present invention relates to a solid-state image sensor which includes a plurality of pixel cells that generate signal charges in accordance with incident light.

## Technological Background

A gettering technique has been a known technique to form a gettering layer on the reverse side of a semiconductor wafer so as to collect and capture metallic contaminants present thereon. The background of such a gettering technique is described in LSI Handbook, Japanese Institute of Electronics, Information and Communication Engineers, first printing of first edition, pp358-364, published by Ohm-sha.

Also, Japanese Unexamined Patent Application Publication No.2002-43557 describes an example in which the gettering technique is applied to a solid-state image sensor. Herein, gettering layers are stacked outside a well (mainly under the well) that surrounds a pixel region.

If a solid-state image sensor is contaminated with metal or the like, in general, a dark output occurs from the contaminated area, thereby reducing the S/N of an image signal.

In particular, the metal contamination is conspicuous in a pixel region formed in an epitaxial layer. Contaminants of such metallic impurities include metals in a material gas for epitaxial growth or those used for processing equipment (such as gas conduits). The dark output derived from the metallic impurities directly acts upon the pixel region in the epitaxial layer, whereby the S/N of an image signal is significantly reduced.

In this context, the inventors of the present application made experiments on contamination with iron in the processing step, which is a main factor of the dark output and often used in processing equipment. In the experiments, solid iron was dissolved on a silicon substrate which had been heated to 900°C. The result was that the substrate was contaminated with the iron from its surface up to a depth of 5μm, which may cause degradation in device characteristics such as the dark output.

According to the experiment results, it can be assumed that the metal contamination occurring in the processing steps of the solid-state image sensor is to have direct effects on the pixel region in the vicinity of the surface.

However, the gettering layer is formed on the reverse side of the substrate or under the well by the aforementioned conventional gettering technique. This causes a problem that gettering capability is not sufficient in the pixel region which is intensively contaminated with metal because the gettering layer is substantially spaced away from the pixel region (the substrate surface).

With the progress of device miniaturization of the solid-state image sensor, in particular, the overall gettering capability reduces as temperature in the processes lowers, so that the contamination cannot be sufficiently eliminated from the pixel region.

## Disclosure of the Invention

It is therefore an object of the present invention to provide an effective gettering technique for eliminating contamination from the solid-state image sensor (the pixel region). Now, the present invention will be described below.

(1) A solid-state image sensor according to the present invention includes a plurality of pixel cells which generate signal charges in accordance with incident light. A gettering region is provided in an area of at least a part of the plurality of pixel cells.

(2) It is preferable that the plurality of pixel cells are formed in a well provided on a semiconductor substrate. The gettering region is provided inside the well.

(3) It is preferable that the gettering region is provided independently in each of the pixel cells.

(4) It is preferable that the gettering region is formed at a depth substantially equal to that of a layer in which photoelectrical conversion is performed for the pixel cells.

(5) It is preferable that the gettering region is provided in an area of the pixel cells where light is blocked.

(6) It is preferable that the gettering region has an average impurity concentration of $1E20cm^{-3}$ or more.

(7) It is preferable that in the gettering region an average area concentration of iron is $1E10cm^{-2}$ or more.

(8) It is preferable that the gettering region is a region where lattice defects are present.

(9) It is preferable that the gettering region contains at least one of boron, phosphorus, arsenic, and antimony as an impurity.

(10) It is preferable that the gettering region is provided at a location to which a constant voltage is applied.

(11) It is preferable that the gettering region and a region in contact with a metal conductor are provided in an area of at least a part of the pixel cells.

**Brief Description of the Drawings**

Fig. 1 is a view showing the configuration of a light-receiving face of a solid-state image sensor 10;
Fig. 2 is a view showing an equivalent circuit of a pixel cell 11;
Fig. 3 is a cross-sectional view taken along the line A-A' shown in Fig. 1;
Fig. 4 is a cross-sectional view taken along line B-B' shown in Fig. 1;
Fig. 5 is a view showing the configuration of a light-receiving face of a solid-state image sensor 30;
Fig. 6 is a view showing an equivalent circuit of a pixel cell 41;
Fig. 7 is a cross-sectional view taken along the line C-C' shown in Fig. 5;
Fig. 8 is a cross-sectional view taken along the line D-D' shown in Fig. 5; and
Fig. 9 shows experimental data which represents the relation between the average impurity concentration in gettering region and the dark output from solid-state image sensor.

**Best Mode For Carrying Out the Invention**

Now, embodiments according to the present invention will be described below with reference to the accompanying drawings.

[First Embodiment]

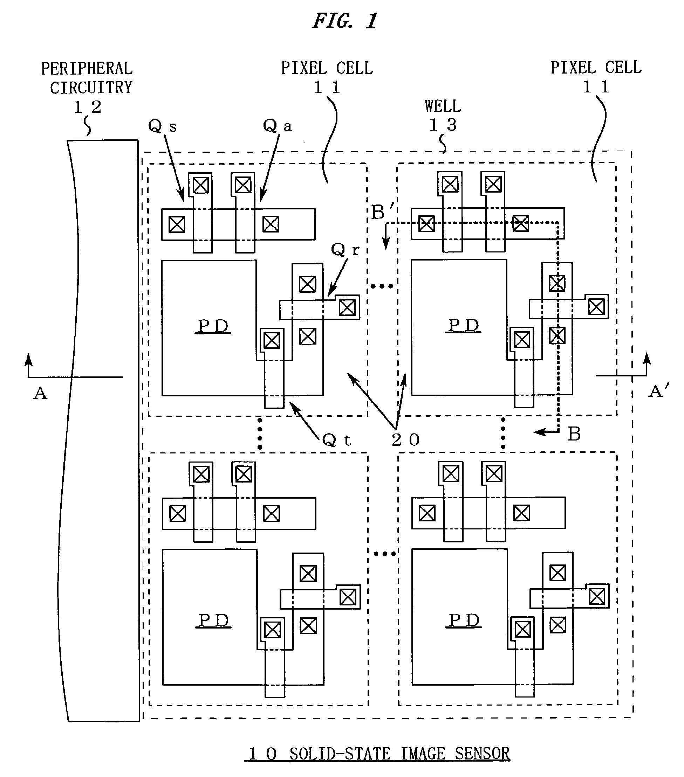

Fig. 1 is a view showing the configuration of a light-receiving face of a solid-state image sensor 10.
As shown in Fig. 1, the solid-state image sensor 10 generally includes pixel cells 11 arranged in an array and peripheral circuitry 12 having a vertical scan circuit or the like. The plurality of pixel cells 11 are formed inside a well 13.

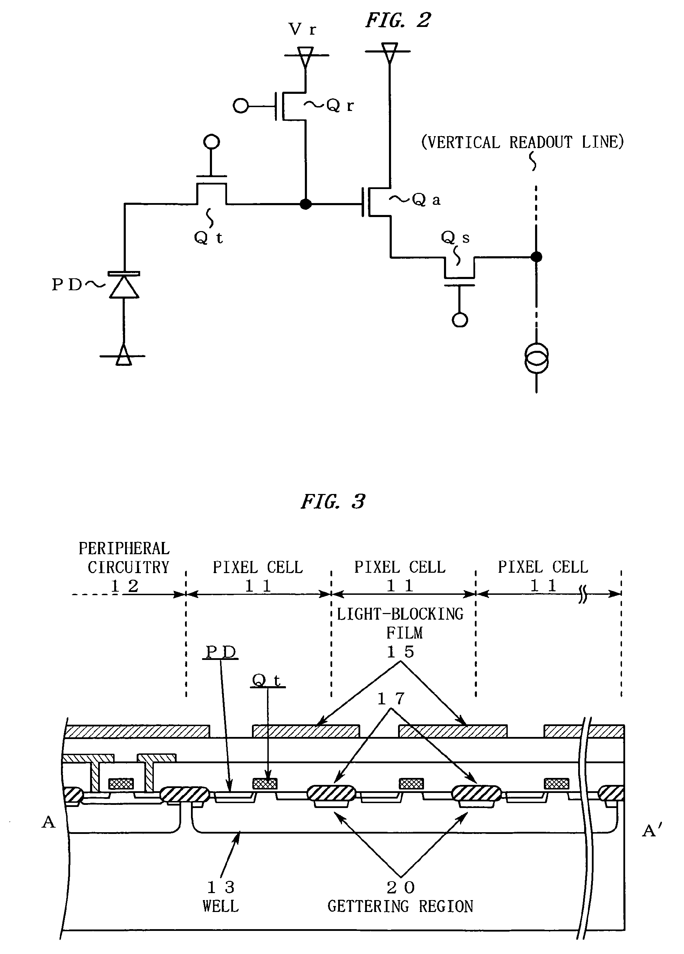

Fig. 2 is a view showing an equivalent circuit of the pixel cell 11.
The pixel cell 11 has the following elements formed therein by patterning:

(1) A photodiode PD for photoelectric conversion of incident light into signal charges;
(2) A MOS switch Qr for reset operations;
(3) A MOS switch Qt for reading signal charges from the photodiode PD;
(4) An amplification element Qa for converting the read signal charges into a voltage signal; and
(5) A MOS switch Qs for selecting an output row.

Fig. 3 is a cross-sectional view taken along the line A-A' shown in Fig. 1.
As shown in Fig. 3, the surface of the pixel cells 11 is covered with a light-blocking film 15 except the opening of the photodiode PD.
A field oxidation film 17 is formed as appropriate on regions other than the circuit elements of the pixel cells 11 so as to separate and isolate neighboring pixel cells 11 from each other. A gettering region 20 is formed under the field oxidation film 17. The gettering region 20 is a region with a high impurity concentration in which the average impurity concentration of such as boron meets the following equation.
$1E20cm^{-3} \leq$ Average impurity concentration $\leq 1E23cm^{-3}$.
The upper limit $1E23cm^{-3}$ is substantially equal to the concentration of metal boron. The grounds for the lower limit $1E20cm^{-3}$ will be explained in detail below with reference to experimental data.
Inside the gettering region 20 lattice defects such as dislocation loops, stacking faults, or vacancies are present. Because the lattice defects are present within the gettering region 20 but not in the depletion region of the photodiode PD, it is thus less likely to cause leak current in the photodiode PD.
Such a gettering region 20 captures iron contaminants; as a result, an average area concentration of iron therein is $1E10cm^{-2}$ or more.
To form such a gettering region 20, for example, boron may be introduced by ion implantation before the field oxidation film 17 is formed and then annealed in an atmosphere of nitrogen (at 950°C, for 30 minutes). After this treatment, oxidation is performed at a high temperature of about 1000°C to form a thick field oxidation film 17 on the gettering region 20.
To form the gettering region 20 in an alternative manner, boron may be introduced to a region under the field oxidation film 17 through the field oxidation film 17 by the high energy ion implantation.

[Effects of the first embodiment]

The aforementioned gettering region 20 has the following features.

(A) The gettering region 20 is provided within a region (or in a plurality of layers) in which the pixel cells 11 are formed as circuits. Accordingly, as compared with the aforementioned conventional technique, the distance between the gettering region 20 and the pixel cells 11 is substantially reduced, thereby achieving a higher gettering effect for the pixel cells 11. As a result, the gettering region 20 achieves a great gettering effect on the pixel cells 11 which are vulnerable to metal contamination, increasing the S/N of the solid-state image sensor 10 easily.

(B) The gettering region 20 is present inside the well 13 that surrounds the pixel cells 11. Accordingly, the gettering region 20 directly acts upon the pixel cells 11 from inside the well 13 to attain a further enhanced gettering effect.

(C) The gettering region 20 is formed at a depth substantially equal to that of the depletion region of the photodiode PD. Therefore, it is possible to attain a high gettering effect on the depletion region of the photodiode PD. This causes contaminant metal present in the depletion region of the photodiode PD to be greatly eliminated, thereby making it possible to significantly reduce dark outputs occurring in this depletion region. Consequently, the S/N of the solid-state image sensor 10 can be surely enhanced.

(D) The gettering region 20 is provided at a location where light is blocked with the light-blocking film 15. For this reason, even while the solid-state image sensor 10 is being illuminated with light, the gettering region 20 is maintained in a dark state. Generally, heavy metal donors which pair with boron in the gettering region 20 are partially separated when illuminated with white light. However, in this embodiment, the gettering region 20 are maintained in a dark state so that separation of captured metal is to be less, thereby making it possible to obtain a more stable continuous gettering effect.

(E) Lattice defects are present in the gettering region 20. Irregular structures of lattice defects cause lattice strain on the surrounding crystalline. The lattice strain serves as the gettering center of heavy metals. Accordingly, the gettering region 20 can capture metal contaminants more effectively by the gettering effect of the lattice strain.

(F) In particular, the gettering region 20 here can be a region not in contact with metal conductor. Such a gettering region 20 is able to be positioned more freely irrespective of the patterning of metal conductor. It is thus possible to place the gettering region 20 as appropriate in the vicinity of the depletion region of the photodiode PD. In this case, it is possible to make an intensive and efficient gettering effect on this depletion region. As a result, dark outputs which would otherwise occur in this depletion region can be effectively reduced to attain an efficiently enhanced S/N for the solid-state image sensor 10.

Now, another embodiment will be described.

[Second embodiment]

The structure of a pixel cell according to the second embodiment is the same as that of the first embodiment (Figs. 1 and 2), and thus will not be repeatedly described.

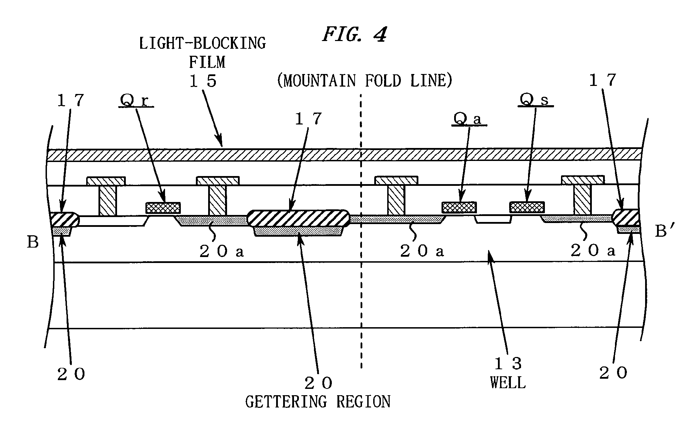

Fig. 4 is a cross-sectional view taken along the line B-B' shown in Fig. 1.

As shown in Fig. 4, in the second embodiment, a gettering region 20a is provided in the region of the MOS switch Qr (to which a reset voltage is applied), the drain region of the amplification element Qa, and the region of the MOS switch Qs (which is connected to the vertical readout line). In particular, one of these regions which is in ohmic contact with the metal conductor may also be referred to as a contact region to distinguish it from the gettering region which is not in ohmic contact with the metal conductor. In these gettering regions 20a, an impurity such as phosphorus is introduced with an average impurity concentration of $1E20cm^{-3}$ or more.

Also, inside the gettering region 20a lattice defects such as dislocation loops, stacking faults, or vacancies are present.

To form such a gettering region 20a, for example, phosphorus may be introduced from the surface of a semiconductor substrate by ion implantation, and thereafter annealed for activation, for example, in an atmosphere of nitrogen at a temperature of $950°C$ or less for about 30 minutes.

Such a gettering region 20a captures iron contaminants so that the average area concentration of iron is $1E10cm^{-2}$ or more therein.

[Effects of the second embodiment]

As described above, the second embodiment provides an additional gettering region 20a. It is therefore possible to further enhance the gettering effect described in relation to the first embodiment.

Now, another embodiment will be described below.

[Third embodiment]

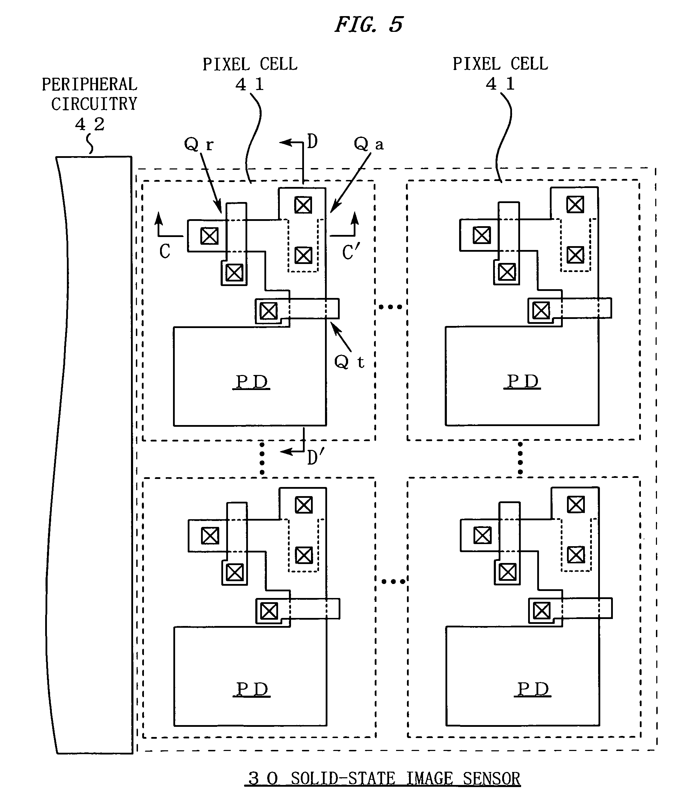

Fig. 5 is a view showing the configuration of a light-receiving face of a solid-state image sensor 30.

As shown in Fig. 5, the solid-state image sensor 30 includes pixel cells 41 arranged in an array and peripheral circuitry 42 having a vertical scan circuit or the like.

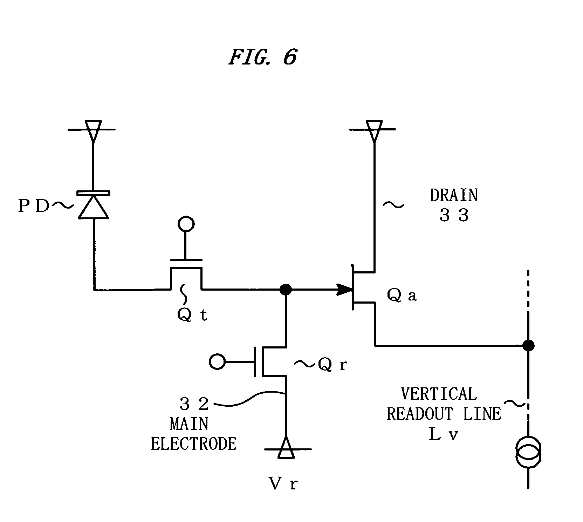

Fig. 6 is a view showing an equivalent circuit of the pixel cell 41.

The pixel cells 41 are patterned with a photodiode PD for photoelectric conversion of incident light into signal charges, a MOS switch Qt for reading signal charges from the photodiode PD, a MOS switch Qr for reset operations, and an amplification element Qa of a junction type FET for converting the read signal charges into a voltage signal.

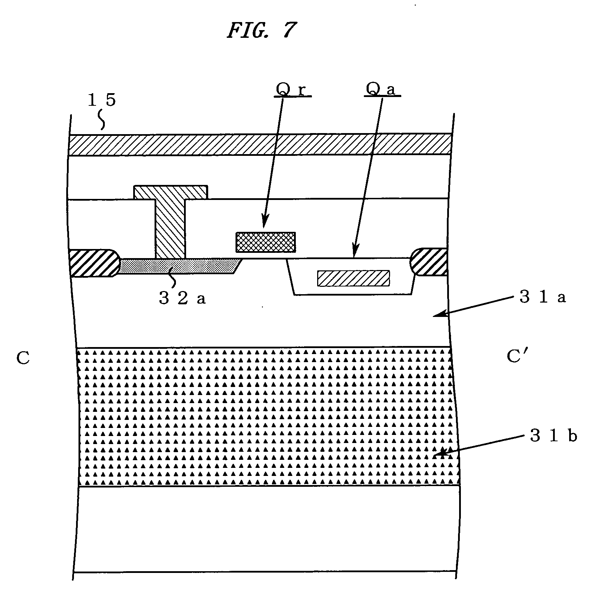

Fig. 7 is a cross-sectional view taken along the line C-C' shown in Fig. 5.

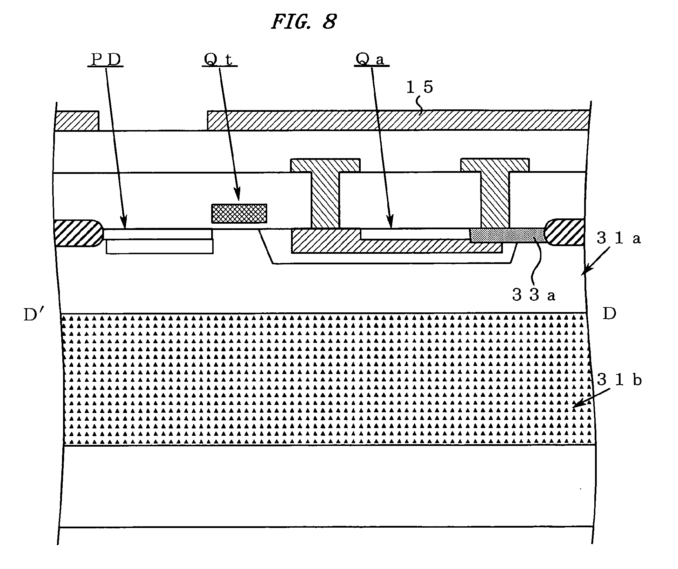

Fig. 8 is a cross-sectional view taken along the line D-D' shown in Fig. 5.

As shown in Figs. 7 and 8, in the third embodiment, gettering regions 32a and 33a are provided on a main electrode 32 of the MOS switch Qr (by which a reset voltage is applied) and the drain 33 of the amplification element Qa, respectively. In particular, one of these regions which is in ohmic contact with the metal conductor may also be referred to as a contact region to distinguish it from the gettering region which is not in ohmic contact with the metal conductor.

In the gettering region 32a, an impurity such as boron is introduced with an average impurity concentration of $1E20cm^{-3}$ or more. On the other hand, in the gettering region 33a, an impurity such as phosphorus is introduced with an average impurity concentration of $1E20cm^{-3}$ or more.

Furthermore, inside the gettering regions 32a and 33a lattice defects such as dislocation loops, stacking faults, or vacancies are present.

To form these gettering regions 32a and 33a, for example, boron fluoride or phosphorus may be introduced by ion implantation, and thereafter annealed in an atmosphere of nitrogen at a temperature of 950°C or less for about 30 minutes.

Such gettering regions 32a and 33a capture iron contaminants so that the average area concentration of iron is $1E10cm^{-2}$ or more therein.

In the third embodiment, the semiconductor substrate is subjected to intrinsic gettering (IG), which is one conventional technique, to form a micro-defect region (Bulk Micro Default BMD) 31b and a no-defect region (DZ region) 31a on the surface of the substrate.

The micro-defect region 31b is able to capture metal contaminants from below the pixel cells 41, thereby providing a more positive gettering effect.

[Effects of the third embodiment]

In the third embodiment, the gettering regions 32a and 33a can provide the same effects as those of the first embodiment.

The third embodiment also provides three additional effects as follows.

(1) In general, the size of the gettering layer is large in the conventional gettering technique since the gettering layer is provided for each substrate or each well. In addition to being large in size, such a gettering layer also contains impurities and defects with a high concentration so that it is difficult to prevent adverse effects on the device structure, function, and operation of the pixel cells. For this reason, in the conventional technique, it is necessary to design a gettering layer and a pixel cell with sufficient distance between them.

However, in this embodiment, the gettering regions 32a and 33a are designed to be provided for each pixel cell 41. This makes it possible to locally dispose a gettering region selectively in an area not to have influence on the device structure, function, or operation of the pixel cell 41. As a result, it is possible to surely reduce adverse effects on the device structure, function, or operation of the pixel cell 41 while exerting an enhanced gettering effect on the pixel cell 41.

(2) In the third embodiment, the gettering regions 32a and 33a are formed in part of the area of circuit elements that constitute the pixel cell 41. This may cause a part of the original area to slightly increase in size; however, there is no need to provide an additional area designated for the gettering region. Accordingly, even though the gettering regions 32a and 33a are additionally provided within the limited area of the pixel cell 41, it causes almost no problems such as unnecessary increases in size of the pixel cell 41 and in the chip size, and a reduction in effective light-receiving area.

(3) In the third embodiment, the gettering regions 32a and 33a are provided at a selected location where a constant voltage is applied. More specifically, it is possible to apply a constant voltage using polysilicon or silicide.

Such a location is sustained at a low impedance as a circuit by a constant voltage circuit or ground line. This makes it possible to immediately absorb a dark current which is generated by a contaminant captured within the gettering regions 32a, 33a. As a result, it is possible to surely confine a dark current which is generated by a captured contaminant, and to further improve the S/N of an image signal.

In the third embodiment, the gettering region is disposed selectively at a location where a constant voltage is originally applied; however, the present invention is not limited thereto. If a new gettering region is created, an additional constant voltage line may be connected via a conductor to the new gettering region.

[Experimental data]

Now, the relation between the average impurity concentration in a gettering region according to the present invention and the dark output from a solid-state image sensor will be verified using experimental data.

Now, the procedure of the experiment will be described below. First, as described in the first through third embodiments, a large number of solid-state image sensors are prepared as samples which have a gettering region within the region of a pixel cell. Boron with various concentrations is introduced into the gettering regions of these samples.

Solid iron is dissolved into the samples at a temperature of $900°C$ until the maximum solid solubility thereof becomes $4.2E13cm^{-3}$. After the iron contamination, the dark output is measured for each sample.

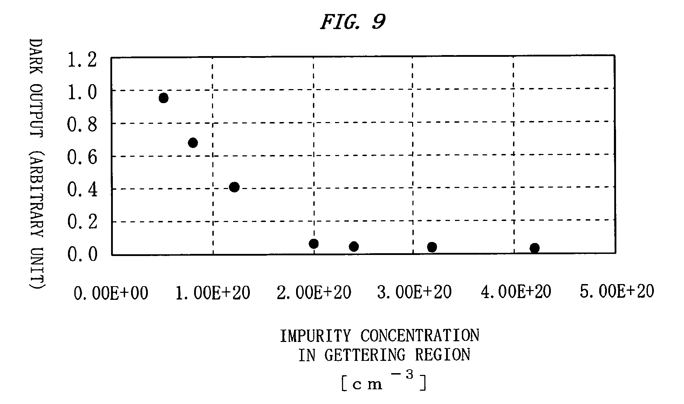

Fig. 9 is a plot representing the relation between the dark output measured in this manner and the average impurity concentration of boron in the gettering region.

From the experimental results shown in Fig. 9, it can be seen that the dark output is sharply reduced to half when the average impurity concentration of the gettering region is raised up to $1E20cm^{-3}$. Around the average impurity concentration of $1E20cm^{-3}$, an inflection point appears on the downward curve of the dark output, and the sharp decrease in dark output changes to a slightly gentle decrease. The decrease in dark output further continues even beyond the average impurity concentration of $1E20cm^{-3}$, finally reaching to almost zero at the average impurity concentration of $2E20cm^{-3}$ (i.e., below the measurement limit).

The experimental results show that the average impurity concentration is preferably set to $1E20cm^{-3}$ or greater (more preferably $2E20cm^{-3}$ or greater) when the gettering region is formed within the area of a pixel cell. Setting the average impurity concentration in this way makes it possible to reduce the dark output from the solid-state image sensor to almost half (or almost zero).

It can be estimated from the halved dark output that the gettering region has captured about a half of the iron contaminant in the pixel cell. In this case, the average area concentration of iron within the gettering region will be about $1E10cm^{-2}$ by the equation below;

$$(4.2E13 \ cm^{-3}) \times (\text{contamination depth of } 5\mu m)/2 \approx 1E10cm^{-2}.$$

Therefore, when a region of a pixel cell with a high impurity concentration, which does not contain iron originally, shows a high average area concentration of iron (e.g., $1E10cm^{-2}$ or more), it can be determined that the region with a high impurity concentration is the gettering region according to the present invention.

However, needless to say that the average area concentration of iron within the gettering region varies with the amount of iron contaminant. Therefore, it cannot be simply determined that an area with a low average area concentration of iron (e.g., below $1E10cm^{-2}$) is not the gettering region according to the present invention.

[Supplemental items of the embodiments]

In the aforementioned embodiments, a gettering region is formed by introducing impurities. This impurity introduction is a particularly preferable technique for locally forming a gettering region as in the aforementioned embodiments. However, the present invention is not limited thereto. For example, the gettering region may also be formed using strains resulting from machining or through the formation of film. Alternatively, the gettering region may be formed by controlling the atmosphere for heat treatment.

In the aforementioned embodiments, the gettering region is formed by introducing boron or phosphorus. Especially, boron is very effective to getter iron which is a main contaminant in the pixel region. However, the present invention is not limited to such an impurity. For example, at least one of boron, phosphorus, arsenic, and antimony is a preferable impurity for forming a gettering region.

The invention is not limited to the above embodiments and various modifications may be made without departing from the spirit and scope of the invention. It should be understood that the embodiments described above are shown as a way of examples with regard to all respects and should not be interpreted restrictively. The scope of the invention is represented not by the Specification but by the Claims. Any improvement may be made in part or all of the components.

**Industrial Availability**

As described above, the present invention provides a gettering region within the region of a pixel cell. Accordingly, the gettering region and the pixel cell can be more closely spaced from each other than in the prior art, which provides an enhanced gettering effect on the pixel cell. As a result, it is able to implement a solid-state image sensor with less dark output easily.

**Claims**

1. A solid-state image sensor comprising a plurality of pixel cells which generate signal charges in accordance with incident light, wherein
   a gettering region is provided in an area of at least a part of said pixel cells.

2. The solid-state image sensor according to Claim 1, wherein:

   said plurality of pixel cells are formed in a well provided on a semiconductor substrate; and
   said gettering region is inside said well.

3. The solid-state image sensor according to any one of Claims 1 and 2, wherein
   said gettering region is provided independently in each of said pixel cells.

4. The solid-state image sensor according to any one of Claims 1 to 3, wherein
   said gettering region is formed at a depth substantially equal to that of a layer in which photoelectrical conversion is performed for said pixel cells.

5. The solid-state image sensor according to any one of Claims 1 to 4, wherein
   said gettering region is provided at a location in an area of said pixel cells, the location where light is blocked.

6. The solid-state image sensor according to any one of Claims 1 to 5, wherein
   said gettering region has an average impurity concentration of $1E20cm^{-3}$ or more.

7. The solid-state image sensor according to any one of Claims 1 to 6, wherein
   in said gettering region an average area concentration of iron is $1E10cm^{-2}$ or more.

8. The solid-state image sensor according to any one of Claims 1 to 7, wherein
   said gettering region is a region where lattice defects are present.

9. The solid-state image sensor according to any one of Claims 1 to 8, wherein
   said gettering region contains at least one of boron, phosphorus, arsenic, and antimony as an impurity.

10. The solid-state image sensor according to any one of Claims 1 to 9, wherein
    said gettering region is provided at a location to which a constant voltage is applied.

11. The solid-state image sensor according to any one of Claims 1 to 10, wherein
    said gettering region and a region in contact with a metal conductor are provided in an area of at least a part of said pixel cells.

## FIG. 1

PERIPHERAL
CIRCUITRY
1 2

PIXEL CELL
1 1

WELL
1 3

PIXEL CELL
1 1

Qs          Qa

B'

Qr

A

Qt          20

A'

B

P D          P D

P D          P D

1 0 SOLID-STATE IMAGE SENSOR

*FIG. 2*

*FIG. 3*

*FIG. 4*

LIGHT-BLOCKING
FILM
1 5

(MOUNTAIN FOLD LINE)

1 7

Qr

1 7

Qa

Qs

1 7

B

B′

2 0 a

2 0 a

2 0 a

2 0

2 0

1 3
WELL

2 0

GETTERING REGION

## FIG. 5

3 0 SOLID-STATE IMAGE SENSOR

FIG. 6

PD~

Qt

32
MAIN
ELECTRODE

~Qr

Vr

DRAIN
3 3

~

Qa

VERTICAL
READOUT LINE ~
L v

FIG. 7

## FIG. 8

PD  Qt  Qa

15

31a

33a

D'  D

31b

## FIG. 9

<div align="center">

**INTERNATIONAL SEARCH REPORT**

</div>

| International application No. |
| --- |
| PCT/JP03/07648 |

**A. CLASSIFICATION OF SUBJECT MATTER**
Int.Cl⁷ H01L27/146, H01L21/322

According to International Patent Classification (IPC) or to both national classification and IPC

**B. FIELDS SEARCHED**

Minimum documentation searched (classification system followed by classification symbols)
Int.Cl⁷ H01L27/146, H01L21/322

Documentation searched other than minimum documentation to the extent that such documents are included in the fields searched

| | | | |
| --- | --- | --- | --- |
| Jitsuyo Shinan Koho | 1922–1996 | Jitsuyo Shinan Toroku Koho | 1996–2003 |
| Kokai Jitsuyo Shinan Koho | 1971–2003 | Toroku Jitsuyo Shinan Koho | 1994–2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y | JP 11-307752 A (Toshiba Corp.),<br>05 November, 1999 (05.11.99),<br>Full text; all drawings<br>(Family: none) | 1-4,6,7,10-11<br>5,8,9 |
| X<br>Y | JP 6-342798 A (Matsushita Electronics Corp.),<br>13 December, 1994 (13.12.94),<br>Full text; all drawings<br>(Family: none) | 1-4,6-9<br>5 |
| Y | JP 2002-165132 A (Innotech Corp.),<br>07 June, 2002 (07.06.02),<br>Full text; all drawings<br>(Family: none) | 5 |

☐ Further documents are listed in the continuation of Box C.   ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 15 August, 2003 (15.08.03) | 02 September, 2003 (02.09.03) |

| Name and mailing address of the ISA/<br>Japanese Patent Office | Authorized officer |
| --- | --- |
| Facsimile No. | Telephone No. |

Form PCT/ISA/210 (second sheet) (July 1998)